(19) Europäisches Patentamt
European Patent Office
Office européen des brevets

(11) **EP 4 644 920 A1**

(12) **EUROPÄISCHE PATENTANMELDUNG**

(43) Veröffentlichungstag:
05.11.2025 Patentblatt 2025/45

(21) Anmeldenummer: 24173406.0

(22) Anmeldetag: 30.04.2024

(51) Internationale Patentklassifikation (IPC):
*G01R 29/12* (2006.01)   *G01R 15/14* (2006.01)
*G01R 15/16* (2006.01)   *G01R 19/00* (2006.01)

(52) Gemeinsame Patentklassifikation (CPC):
**G01R 15/144; G01R 15/165; G01R 29/12;**
G01R 19/0084

(84) Benannte Vertragsstaaten:
**AL AT BE BG CH CY CZ DE DK EE ES FI FR GB
GR HR HU IE IS IT LI LT LU LV MC ME MK MT NL
NO PL PT RO RS SE SI SK SM TR**
Benannte Erstreckungsstaaten:
**BA**
Benannte Validierungsstaaten:
**GE KH MA MD TN**

(71) Anmelder: **Siemens Aktiengesellschaft
80333 München (DE)**

(72) Erfinder:
• **Gashi, Indrit**
  **81241 München (DE)**
• **Raab, Oliver**
  **94496 Ortenburg (DE)**
• **Santos Wilke, Hans**
  **85599 Parsdorf (DE)**
• **Weikert, Robert**
  **92342 Burggriesbach (DE)**

(74) Vertreter: **Siemens Patent Attorneys
Postfach 22 16 34
80506 München (DE)**

(54) **VORRICHTUNG UND VERFAHREN ZUR BESTIMMUNG EINER ELEKTRISCHEN GRÖSSE EINES ZU VERMESSENDEN ELEKTRISCHEN LEITERS**

(57) In dem vorgeschlagenen Verfahren und der vorgeschlagenen Anordnung zur Bestimmung einer elektrischen Größe (E) eines stromdurchflossenen elektrischen Leiters (con), wird eine erste und eine zweite Messung einer ersten elektrischen Größe des elektrischen Leiters (con) vorgenommen und daraus in einem Messsignalverarbeitungsschritt (cal) eine weitere elektrische Größe (U) bestimmt. Dabei wird genutzt, dass der zu vermessende elektrische Leiter (con) in zwei unterschiedlichen Abständen (d1, d2) relativ zu den Messpositionen verläuft.

FIG 2

**Beschreibung**

Die Erfindung betrifft eine Vorrichtung umfassend wenigstens eine berührungslose Messeinrichtung zur Messung einer elektrischen Größe eines zu vermessenden elektrischen Leiters sowie ein Verfahren zur berührungslosen Messung und Bestimmung einer elektrischen Größe eines stromdurchflossenen elektrischen Leiters.

Die exakte Bestimmung elektrischer Größen wie elektrischer Strom, elektrische Spannung, elektrischer Energiefluss, ist eine wichtige Aufgabe für unterschiedliche Anwendungsfelder, beispielsweise in der industriellen Automatisierung, der Gebäudetechnik oder auch in großflächigen elektrischen Verteilernetzen. Insbesondere im Zuge der voranschreitenden Umstellung auf erneuerbare Energien und der Dezentralisierung der Energieerzeugung wird es in Zukunft von entscheidender Bedeutung sein, elektrische Größen von stromführenden Bauteilen exakt und örtlich aufgelöst abbilden zu können. Insbesondere in der industriellen Automatisierung, sei es in Schaltanlagen oder kleiner dimensioniert auf Leiterplatten wird es zunehmend wichtiger elektrische Größen von stromführenden Bauteilen zuverlässig bestimmen zu können.

Zur Durchführung von Strommessungen stehen bereits unterschiedliche Messverfahren zur Verfügung. Bekannt sind als berührungslose Messmethoden beispielsweise Hall-Sensoren oder Rogowski-Spulen. Auch im Bereich der Spannungsmessung sind bereits berührungslose Verfahren bekannt. Beispielsweise das Prinzip des Elektroskops oder das des Voltmeters, insbesondere der Einsatz eines mikroelektromechanischen Voltmeters, auch bezeichnet als mikroelektromechanische Feldmühle. Dieses Messprinzip beruht auf einer Messung der zeitlichen Veränderung einer elektrischen Kapazität mittels eines mikroelektromechanischen Systems. Die zeitliche Veränderung der Kapazität beziehungsweise zeitlich abhängige Abschattung der Kapazität wird mechanisch mit einem elektrischen, elektrostatischen oder thermischen Aktor herbeigeführt. Um die Veränderung der Kapazität zu messen, wird ein Verschiebungsstrom durch einen Strom-Spannungs-Wandler erfasst und hierdurch ein Messsignal generiert. Der Einfluss der zu messenden elektrischen Spannung auf das Messergebnis wird dadurch eliminiert, dass die Spannung konstante Teile enthält und der Strom-Spannungs-Wandler während der Schaltflanken der Spannung abgetastet wird. So kann eine Impulsantwort auf Spannungsänderungen der zu messenden Spannung, die auch auf den Messkondensator wirken, ausgeblendet werden.

Es wird also die Eigenschaft des kapazitiven Messprinzips genutzt, dass ein Signal nur detektiert werden kann, wenn sich am Kondensator Ladungen verschieben, die einen Verschiebungsstrom I von t initiieren. Hierfür gilt die Gleichung

$I(t) = dC/dt \cdot U + dU/dt \cdot C$, wobei C die Kapazität des Kondensators ist und U die am Kondensator anliegende Spannung. Die Kapazität des Kondensators, bzw. die Kapazität zwischen einem Messobjekt, beispielsweise einem stromführenden Leiter, und dem Sensor, insbesondere einem mikroelektromechanischen Voltmeter, kann durch Änderung der Fläche der Kondensatorplatten, insbesondere durch Einschieben von Blenden in den Kondensatorspalt, durch Änderung des Abstands der Kondensatorplatten oder durch Änderung der relativen Dielektrizitätskonstante des zwischen den Platten befindlichen Mediums geändert werden, was aus den Anmeldungsschriften DE102010035381A1 und DE102008052477A1 bekannt ist.

Waren bisherige bewehrte Spannungsmessungen in den meisten Fällen berührende Verfahren, beispielsweise mit einem Analog-Digital-Konverter, kann mittels einer Feldmühle ein berührungsloses Verfahren realisiert werden.

Berührendes Verfahren heißt, dass ein physischer Kontakt zum Messobjekt hergestellt werden muss, um eine direkte Messung im Stromkreis vorzunehmen. Hierzu muss also eine Messvorrichtung entweder fest integriert sein oder alternativ die Isolation der zu messenden elektrischen Leitung unterbrochen, d. h. beschädigt werden. Dieser notwendige direkte physische Kontakt zur stromführenden Leitung hat insbesondere bei bereits bestehenden Anlagen ("Brownfield") den Nachteil, dass diese Verfahren zur Vornahme einer Messung oder zur Installation zwischenzeitlich vom Netz getrennt werden müssen und im späteren Betrieb strenge Sicherheitsanforderungen eingehalten werden müssen, was die elektrische Sicherheit betrifft. Auch für die Datenübertragung muss eine galvanische Trennung realisiert werden.

Unter einem berührungslosen Verfahren wird ein Verfahren bzw. eine Vorrichtung angesehen oder verstanden, welche mit dem zu vermessenden elektrischen Leiter galvanisch getrennt angeordnet ist. Das heißt die Messung an dem elektrischen Leiter wird dadurch vorgenommen, dass das elektrische Feld oder das elektromagnetische Feld, welches vom stromdurchflossenen Leiter ausgeht, mittels eines Sensors erfasst wird. Unter galvanisch getrennt ist also zu verstehen, dass es zwar eine Potentialauswirkung gibt, also dass das elektrische Feld oder ein elektromagnetisches Feld von einem Sensor erfasst werden kann, aber es liegt eine elektrische Isolation vor, so dass kein Strom zwischen dem zu vermessenden Leiter und der Vorrichtung, insbesondere der Messvorrichtung, fließen kann.

Derartige berührungslose Messverfahren sind von großem Vorteil für den Einsatz in bestehenden Systemen, weil diese ohne baulichen Eingriff mit einer Messvorrichtung nachgerüstet werden können. Eine Schwierigkeit dieser berührungslosen Messung jedoch liegt darin, dass bei Messungen nur einer elektrischen Größe, beispielsweise der elektrischen Feldstärke, der Abstand der Messposition also des Sensors zum Messbereich des zu vermessenden elektrischen Leiters höchstgenau sein muss und ebenso exakt reproduzierbar sein muss. Diese Notwendigkeit stellt hohe Anforderungen an mechanische Realisierungen und Einbautoleranzen.

Folglich stellt es sich als technisch erforderlich dar, eine verbesserte Lösung vorzuschlagen, welche die aus dem Stand der Technik bekannten Nachteile vermeidet. Insbesondere soll die vorzuschlagende Lösung eine genauere Bestimmung einer elektrischen Größe ermöglichen.

Beschreibung der Erfindung

Das erfindungsgemäße Verfahren zum Bestimmen einer elektrischen Größe eines stromdurchflossenen elektrischen Leiters umfasst eine erste und eine zweite Messung einer ersten elektrischen Größe des elektrischen Leiters, einen Messsignalverarbeitungsschritt, in dem aus den Messwerten von erster und zweiter Messung eine weitere elektrische Größe bestimmt wird, wobei sich erste und zweite Messung in ihrem Messabstand relativ zum elektrischen Leiter unterscheiden.

Das Verfahren hat den Vorteil eine abstandsunabhängige Ermittlung, einer eigentlich abstandsabhängigen elektrischen Größe zu realisieren. Als abstandsabhängige elektrische Größe seien alle elektrischen Größen gemeint, für deren Bestimmung eine Kenntnis über den genauen Abstand von elektrischem Leiter zur Messeinrichtung bzw. Messelektrode oder Messsensor nötig wäre. Insbesondere kann es sich um eine Spannungsermittlung handeln. Diese wäre durch das erfindungsgemäße Verfahren möglich, ohne den exakten Abstand von Leiter zur Messeinrichtung, sondern lediglich den Abstandsunterschied zu kennen.

Das erfindungsgemäße Verfahren hat zudem den Vorteil aller berührungslosen Messverfahren, nämlich dass sie relativ leicht und ohne baulichen Aufwand und ohne großen Kostenaufwand anwendbar sind. Bisher mussten Anlagen spannungsfrei geschaltet werden und die Spannungsmessung mit zu vermessenden Leitung verdrahtet werden, insbesondere in Schaltschränken kann das Verfahren vorteilhaft eingesetzt werden, ohne dass eine Verdrahtung mit der Spannungsschiene notwendig ist.

Eine vorteilhafte Variante des erfindungsgemäßen Verfahrens umfasst einen Messsignalverarbeitungsschritt, in dem die Bestimmung der weiteren elektrischen Größe ratiometrisch vorgenommen wird. Das ratiometrische Messprinzip ist ein Verfahren zur Messung einer physikalischen Größe, bei dem die Ausgangsspannung oder der Ausgangswert des Sensors im Verhältnis zu einer Referenzspannung oder einem Referenzwert gemessen wird. Bei diesem Prinzip wird die gemessene Größe in Bezug zu einem festgelegten Bezugswert angegeben, anstatt einen absoluten Wert zu liefern. Dies hat den Vorteil, dass Schwankungen der Versorgungsspannung oder des Umgebungseinflusses minimiert werden können, da sie sowohl den Messwert als auch die Referenzspannung gleichermaßen beeinflussen. Dadurch wird die Genauigkeit und Zuverlässigkeit der Messung verbessert.

In einer weiteren vorteilhaften Variante des erfindungsgemäßen Verfahrens unterscheiden sich erste und zweite Messung derart in ihrer Messposition relativ zum elektrischen Leiter, dass eine Messung desselben Leiterabschnitts in unterschiedlichem Abstand zum Leiter erfolgt. Insbesondere wird dazu der Leiter beziehungsweise zumindest der zu vermessende Leiterabschnitt des elektrische Leiters von einem ersten Abstand relativ zur Messeinrichtung zu einem zweiten Abstand relativ zur Messeinrichtung bewegt.

Der Vorteil dieser Variante liegt vor allem darin in ihrem Einsatz ohnehin bewegte elektrische Leitungen zu überwachen.

In einer alternativen vorteilhaften Variante des erfindungsgemäßen Verfahrens unterscheiden sich erste und zweite Messung darin, mittels jeweils einer ersten und einer zweiten Messeinrichtung vorgenommen zu werden. Dabei werden erste und zweite Messeinrichtung derart beidseitig einer Leiterstufe angeordnet, dass sich erste und zweite Messung in ihrer Messposition relativ zum elektrischen Leiter unterscheiden.

Der örtliche Verlauf des elektrischen Leiters ist dafür so gestaltet, dass er in unterschiedlichen Abständen an den Messpositionen, also den Messeinrichtungen vorbeigeführt ist.

Diese Variante hat den Vorteil sehr akkurat zu sein. Anwendung im Bereich elektrischer Baugruppen können sehr vorteilhaft sein.

Insbesondere wird in dem erfindungsgemäßen Verfahren mittels der ersten und zweiten Messung je eine elektrische Feldstärke $E_1$ und $E_2$ erfasst. Im Messsignalverarbeitungsschritt wird daraus, unter Berücksichtigung der Abstandsdifferenz $\Delta d$ die Spannung $U$ bestimmt, gemäß der Formel:

$$U = \frac{E_1 * E_2 * \Delta d}{E_2 - E_1}$$

Beispielsweise wird in dem erfindungsgemäßen Verfahren die Messung der elektrischen Feldstärke mittels einer mikroelektromechanischen Feldmühle vorgenommen. Dabei wird, mittels eines geerdeten Shutters, wiederholt eine Sensorelektrodenanordnung von dem zu messenden Feld abschirmt und wieder dem Feld aussetzt, so dass die Sensorelektrodenanordnung hinter dem Shutter durch Influenz des zu messenden elektrischen Feldes abwechselnd ent- und aufgeladen wird.

Die erfindungsgemäße Anordnung umfasst eine Vorrichtung zum Bestimmen einer elektrischen Größe eines elektrischen Leiters, welche galvanisch getrennt mit dem elektrischen Leiter angeordnet ist, und welche Vorrichtung wenigstens eine Messeinrichtung aufweist, wobei die Anordnung derart ausgestaltet ist, dass zumindest zwei Messungen einer ersten elektrischen Größe des zu vermessenden Leiters vornehmbar sind, die sich in ihrer Messposition relativ zum elektrischen Leiter unterscheiden. Außerdem umfasst die Vorrichtung eine Messsignalverarbeitungseinrichtung, welche ausgestaltet ist, aus den Messwerten eine weitere elektrische Größe zu bestimmen.

In einer vorteilhaften Ausführungsform der Erfindung umfasst die Vorrichtung eine Messeinrichtung, welche einen Sensor zur Messung einer elektrischen Feldstärke umfasst. Die Messung elektrischer Feldstärken kann dazu genutzt werden die am elektrischen Leiter anliegende elektrische Spannung zu bestimmen.

Besonders vorteilhaft ist die Ausführung der erfindungsgemäßen Vorrichtung mit einem als mikroelektromechanischer Feldmühle ausgestalteten Sensor. Die grundsätzliche Funktionsweise der mikroelektromechanischen Feldmühle wurde bereits beschrieben. Eingesetzt in einer erfindungsgemäßen Anordnung zur Erfassung der elektrischen Feldstärke kann es alle Vorteile, insbesondere die geringe bauliche Größe, die Messgenauigkeit, sowie die Messempfindlichkeit, darbieten.

In einer besonders bevorzugten Ausführungsform der erfindungsgemäßen Anordnung ist der elektrische Leiter oder zumindest ein zu vermessender Leiterabschnitt des elektrische Leiters zwischen einem ersten Abstand relativ zur Messeinrichtung und einem zweiten Abstand relativ zur Messeinrichtung beweglich angeordnet. Dies ermöglicht die Vornahme einer Bestimmung einer elektrischen Größe des Leiters gemäß einer vorstehend beschriebenen Variante des erfindungsgemäßen Verfahrens.

So können sich erste und zweite Messung derart in ihrer Messposition relativ zum elektrischen Leiter unterscheiden, dass eine Messung desselben Leiterabschnitts in unterschiedlichem Abstand zum Leiter erfolgt.

In einer alternativen sehr bevorzugten Ausführungsform der erfindungsgemäßen Anordnung weist die Vorrichtung eine erste und eine zweite Messeinrichtung auf, welche erste und zweite Messeinrichtungen derart beidseitig einer Leiterstufe angeordnet sind, dass der Verlauf des elektrischen Leiters vor und nach der Leiterstufe in unterschiedlichen Abständen an den Messeinrichtungen vorbeiführt.

Zweckdienlicherweise ist zumindest eine elektromagnetische Feldabschirmung umfasst, welche die Messeinrichtung bzw. die Messelektroden vor externen elektromagnetischen Feldern abschirmt.

Besonders auf die elektrische Feldstärke als Messgröße, wirkt eine Vielzahl an Störvariablen ein. Es müssen technische Maßnahmen ergriffen werden, um den Einfluss der Störvariablen zu minimieren. Ein Beispiel für diese variablen Störgrößen ist, dass bei einer elektrischen Feldmessung der Abstand zum zu messenden Leiter direkt in das Messsignal mit eingeht. Aber auch andere Effekte, wie die geometrische Ausrichtung des Leiters zu den Sensoren oder externe Störfelder, führen zu fehlerbehafteten, unpräzisen Messungen. Demnach werden die Messvorrichtungen, insbesondere die Messelektroden gegen externe Störgrößen entsprechend abgeschirmt.

In einer weiteren vorteilhaften Ausführungsform der erfindungsgemäßen Vorrichtung umfasst die Signalverarbeitungseinrichtung eine Auswerteelektronik. Insbesondere ist von der Auswerteelektronik eine Rechenlogik umfasst, welche zur Ausgabe digitaler Werte geeignet ist. Beispielsweise ermittelt die Rechenlogik aus den gemessenen elektrischen Feldwerten die zu bestimmende Größe der elektrischen Spannung.

Bevorzugt umfasst die erfindungsgemäße Vorrichtung bzw. die Messsignalverarbeitungseinrichtung eine Signalaufbereitung. Unter Signalaufbereitung ist beispielsweise eine Signalverstärkung zu verstehen. Insbesondere bei mikroelektromechanischen Bauteilen ist eine Signalverstärkung wichtig. Die Signalaufbereitungsvorrichtung muss je Sensor vorgesehen sein. Bei mehreren Sensoren ist jede zweckdienlicherweise einer Signalaufbereitungsvorrichtung zugeordnet. Die Auswerteelektronik wertet dann die Messsignale aller Sensoren aus und bestimmt daraus den gewünschten Wert.

Die somit beschriebenen zweckdienlichen Ausgestaltungsvarianten der erfindungsgemäßen Anordnung bergen den gemeinsamen Vorteil einer sehr verlässlichen, abstandsunabhängigen Spannungsermittlung. Darüber hinaus ist die Anordnung nicht auf einen galvanischen Kontakt zwischen zu messendem Leiter und Messelektronik angewiesen und gewährleistet demnach eine berührungslose Zustandsüberwachung. Dies birgt weitere Vorteile hinsichtlich Sicherheitsanforderungen.

Figurenbeschreibung:

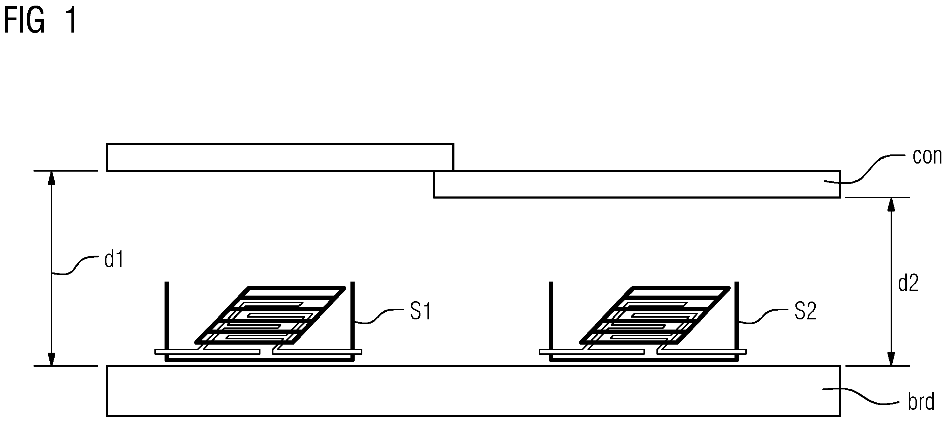

Im Folgenden wird die Erfindung anhand der in den Figuren 1 bis 6 dargestellten Ausführungsbeispiele näher beschrieben und erläutert.

In den Ausführungsbeispielen und Figuren können gleiche oder gleich wirkende Elemente jeweils mit den gleichen Bezugszeichen versehen sein. Die dargestellten Elemente und deren Größenverhältnisse untereinander sind grundsätzlich nicht als maßstabsgerecht anzusehen, vielmehr können einzelne Elemente, zur besseren Darstellbarkeit und/oder zum besseren Verständnis im Verhältnis größer dimensioniert dargestellt sein.

Figur 1    zeigt eine Seitenansicht auf eine Anordnung aus zu vermessendem Leiter con und Vorrichtung,

Figur 2    zeigt eine Seitenansicht auf eine alternative Anordnung aus zu vermessendem Leiter con und Vorrichtung,

Figur 3    zeigt schematisch eine Aufsicht auf eine erfindungsgemäße Anordnung,

Figur 4    zeigt eine schematische Darstellung der Elektrodenanordnung sen einer elektrischen Feldmühle S1,

Figur 5    zeigt eine Seitenansicht auf eine Realisierung einer Leiterstufe auf einer Leiterplatte und

Figur 6    zeigt einen Schnitt durch eine elektrische Maschine, aufweisend beweglich angeordnete Leiter.

Im Gegensatz zur bisherigen Lösung mittels zweier definiert zueinander versetzter Sensoren gibt es auch die Möglichkeit den Leiter selbst zu versetzten.

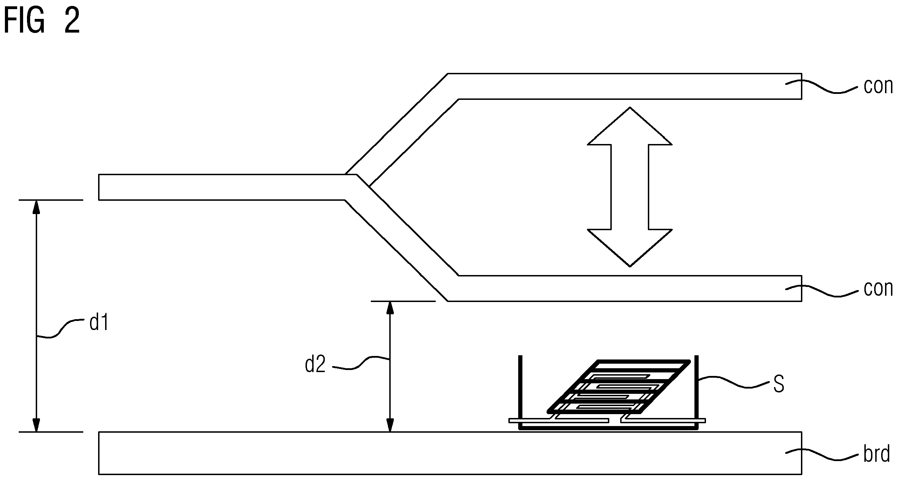

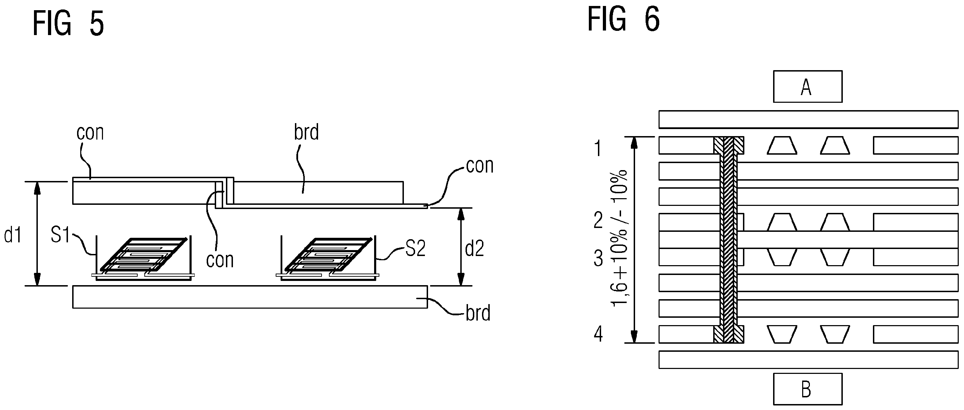

Dies kann statisch baulich erfolgen, wie etwa in Figur 1 und Figur 5 gezeigt, indem eine definierte Leiterstufe ausgebildet wird. Hier kann beispielsweise eine Leiterbahnenverlauf auf Oberseite und Unterseite einer Leiterplatte realisiert werden. Dies kann dynamisch erfolgen, wie in Figur 2 schematisch dargestellt, indem der Leiter beweglich angeordnet ist. Beispielsweise kann das vorgeschlagenen Verfahren idealerweise für die Bestimmung elektrischer Größen von im Anwendungsfall bewegter elektrischer Leiter genutzt werden, vergleiche Figur 6.

Voraussetzung ist dafür eine für den Abgleich zweier Messungen konstante Spannung U. Diese liegt beispielsweise über ein Teach-In oder über eine Werkskalibrierung vor. Des Weiteren soll der zu messende Leiter in einem Abstand zum Sensor liegen, in welchem gilt:

$$E_x \sim \frac{U}{d_x}.$$

Dabei ist die Messgröße des Sensors bevorzugt eine elektrische Feldstärke $E_x$. Diese soll in dem Bereich beider Messabstände $d_x$ noch als antiproportional zum Abstand angenommen werden dürfen.

Während die Figuren 1 und 5 eine Möglichkeit mit zwei Sensoren S1, S2 und zusätzlich mit einem Stufenprofil in der Leiterführung zu arbeiten zeigen. Zeigt Figur 2 eine andere Möglichkeit, nämlich die mechanische Versetzung des Leiters con um einen definierten Abstand. Im Bereich über dem Feldmühlensensor S1 ist der Leiter con flexibel gelagert. Dies kann beispielsweise über eine veränderbare mechanische Anordnung, vergleichbar mit der Bewegung des Ankers in einem klassischen Relais, erfolgen. Damit wird eine Umpositionierung des Leiters um einen definierten Abstand $\Delta d$ realisiert. Mit diesem bekannten Abstandsunterschied $\Delta d$ und den beiden Messungen des elektrischen Feldes E1 und E2 kann nun auf den tatsächlichen Abstand zwischen Feldmühle und Leitung gerechnet werden. Unter der Annahme, dass sich der mechanische Aufbau nicht ändert, kann für alle folgenden Messungen der berechnete Abstand herangezogen werden.

$$U = \frac{E_1 * E_2 * \Delta d}{E_2 - E_1}$$

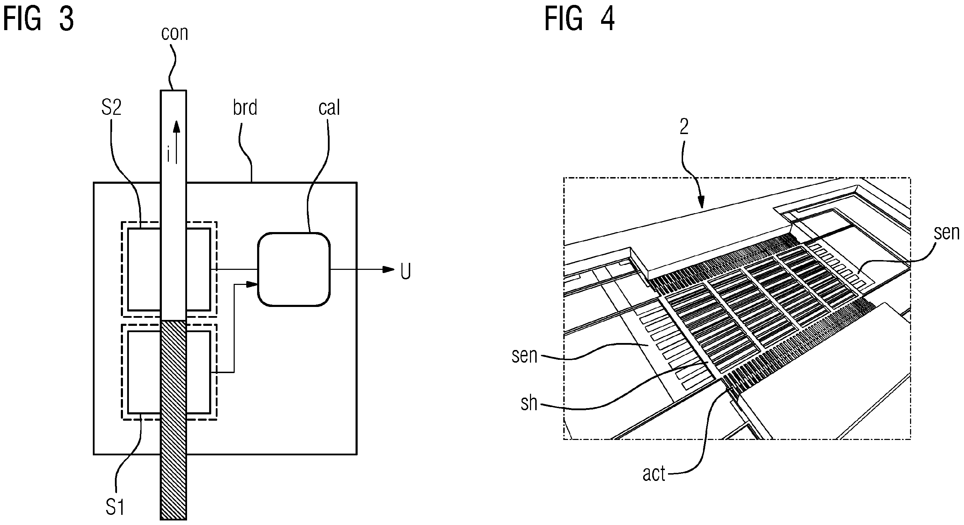

In Figur 3 ist eine Aufsicht auf eine Vorrichtung mit Feldmesssensoren S1 und S2 gezeigt, welche beispielsweise auf einer Leiterplatte brd angebracht sind. Durch Schraffur ist angezeigt, dass der Leiter con auf unterschiedlichen Höhen relativ zu den Sensoren S1 und S2 verläuft. Beispielsweise kann der Leiter ebenso auf einer Leiterplatte brd angeordnet sein, z.B. durch Aufbringung einer Kupferleitbahn auf Ober- und Unterseite der Leiterplatte. Die Dicke der Leiterplatte als $\Delta d$ wäre genau bekannt. Die Leiterstufe könnte durch eine der Durchkontaktierungsbohrungen der Leiterplatte verlaufen. Die Leiterplatten könnten gestackt vorliegen. Zusätzlich dazu ist eine Auswerteeinheit cal gezeigt, in der die beiden Messsignale E1 und E2 der Feldmesssensoren S1 und S2 verrechnet werden. Die Augabe umfasst dann beispielsweise die aus den Messungen bestimmte weitere elektrische Größe, insbesondere die am Leiter con anliegende Spannung U. Es ist auch möglich, dass die Sensorchips S1, S2 auf derselben Leiterplatte aufgebracht werden, wie die zu vermessende Leiterbahn.

In der Figur 4 ist schematisch eine Sensorelektrodenanordnung sen einer elektrischen Feldmühle gezeigt. Das Funktionsprinzip basiert auf einem geerdeten Shutter sh, der wiederholt eine Sensorelektrodenanordnung sen von einem zu messenden Feld E abschirmt und wieder dem Feld E aussetzt. Die Sensorelektroden sen sind bevorzugt als Fingerelektroden ausgeführt. Entsprechend Gaußschem Gesetz, wird die Sensorelektrodenanordnung sen hinter dem Shutter sh durch Influenz des externen elektrischen Feldes E abwechselnd ent- und aufgeladen (Verschiebestrom). Im vorliegenden Fall wird eine miniaturisierte Vorrichtung dazu vorgeschlagen.

Das Voltmeter beziehungsweise die mikroelektromechanische Feldmühle S1, S2 bestimmt die Spannung U eines Leiters con beziehungsweise dessen elektrisches Feld E durch Verschiebeströme auf zwei Sensorelektrodenflächen sen. Diese sind direkt proportional zu dem elektrischen Feld E beziehungsweise der Spannung U des zu vermessenden Leiters con. Die Messgröße Strom I ist abhängig von den Ladungsträgern Q und der Zeit t zu:

$$I = \frac{\Delta Q}{\Delta t}.$$

Die Zeit t ist fix durch die Bauweise des Voltmeters vorgegeben. Die Ladung Q dagegen ist abhängig von der Kapazität C zwischen den Sensorelektroden sen und der Spannung U des zu vermessenden Leiters con:

$$Q = C \cdot U.$$

Die Kapazität C wiederum bestimmt sich in einer vereinfachten Anschauung aus der Fläche A der Sensorelektroden sen, dem Abstand zwischen Sensorelektroden sen und dem zu vermessenden Leiter d sowie der Permittivität ε = $\varepsilon_0\varepsilon_r$ zu:

$$C = \frac{\varepsilon_0\varepsilon_r \cdot A}{d}.$$

Das Messprinzip des beschriebenen mikroelektromechanischen Voltmeters basiert auf der zeitlichen Änderung der Fläche des dem Feld des zu vermessenden Leiters ausgesetzten A:

$$I(t) = U\frac{\varepsilon_0\varepsilon_r}{d}\frac{dA}{dt}$$

Figur 5 zeigt noch einmal eine Seitenansicht vergleichbar zum Schema in Figur 1, jedoch soll deutlicher gezeigt sein, wie so eine Leiterstufe baulich realisiert sein kann: Beispielsweise handelt es sich bei dem zu überwachenden Leiter um eine Leiterbahn, insbesondere um eine Kupferleiterbahn, auf einer Leiterplatte. Diese kann auf Oberseite und Unterseite der Leiterplatte aufgebracht sein. Die Leiterstufe kann durch eine der Durchkontaktierungsbohrungen der Leiterplatte verlaufen, womit oberseitig und unterseitig verlaufender Leiterabschnitt verbunden wären. Die Dicke der Leiterplatte als Δd wäre genau bekannt.

Figur 6 zeigt eine Variante einer dynamischen Versetzung des Leiters, in der der Leiter Teil einer elektrischen Maschine, eines Elektromotors oder eines Generators ist. In einer elektrischen Maschine würde ein zu vermessender Leiter mittels der Rotationsbewegung der elektrischen Maschine zwischen den beiden Messpositionen hin und her bewegt werden. Auch in diesem Fall kann man den Abstandsunterschied Δd genau kennen und für die Ermittlung der zu bestimmenden elektrischen Größe heranziehen.

Zusammenfassend wird festgehalten:

In dem vorgeschlagenen Verfahren und der vorgeschlagenen Anordnung zur Bestimmung einer elektrischen Größe eines stromdurchflossenen elektrischen Leiters con, wird eine erste und eine zweite Messung einer ersten elektrischen Größe des elektrischen Leiters vorgenommen und daraus in einem Messsignalverarbeitungsschritt eine weitere elektrische Größe bestimmt. Dabei wird genutzt, dass der zu vermessende elektrische Leiter in zwei unterschiedlichen Abständen relativ zu den Messpositionen verläuft.

Bezugszeichenliste

| | |
|---|---|
| con | Leiter |
| cal | Messsignalverarbeitung |
| U | Spannung |
| E1, E2 | elektrische Feldstärke |
| E | elektrisches Feld |
| S1, S2, S | Messeinrichtung |
| d1, d2 | Abstand zwischen Leiter und Messeinrichtung, d1-d2= Δd |
| brd | Leiterplatte |
| sen | Sensorelektroden |
| sh | Shutterblende |
| 2 | mikroelektronische Feldmühle |
| act | Aktuator |
| A, B | Seite A, Seite B |

**Patentansprüche**

1.  Verfahren zum Bestimmen einer elektrischen Größe eines stromdurchflossenen elektrischen Leiters (con),

    bei dem eine erste und eine zweite Messung einer ersten elektrischen Größe des elektrischen Leiters (con) vorgenommen werden,
    bei dem in einem Messsignalverarbeitungsschritt (cal) aus den Messwerten von erster und zweiter Messung eine weitere elektrische Größe bestimmt wird,
    wobei sich erste und zweite Messung in ihrer Messposition relativ zum elektrischen Leiter (con) unterscheiden.

2.  Verfahren nach Anspruch 1, bei dem mittels der ersten und zweiten Messung je eine elektrische Feldstärke (E1, E2) erfasst wird, und bei dem im Messsignalverarbeitungsschritt (cal) die am elektrischen Leiter (con) anliegende Spannung (U) bestimmt wird.

3.  Verfahren nach Anspruch 1 oder 2, bei dem in dem Messsignalverarbeitungsschritt (cal) die Bestimmung der weiteren elektrischen Größe ratiometrisch vorgenommen wird.

4.  Verfahren nach einem der vorstehenden Ansprüche, bei dem sich erste und zweite Messung derart in ihrer Messposition relativ zum elektrischen Leiter (con) unterscheiden, dass eine Messung desselben Leiterabschnitts in unterschiedlichem Abstand zum Leiter (con) erfolgt.

5.  Verfahren nach Anspruch 4, bei dem zumindest der zu vermessende Leiterabschnitt des elektrischen Leiters (con) von einem ersten Abstand (d1) relativ zur Messeinrichtung (S1) zu einem zweiten Abstand (d2) relativ zur Messeinrichtung (S1) bewegt wird.

6.  Verfahren nach einem der vorstehenden Ansprüche, bei dem erste und zweite Messung mittels jeweils einer ersten und einer zweiten Messeinrichtung (S1, S2) vorgenommen werden, wobei dazu erste und zweite Messeinrichtung (S1, S2) derart beidseitig einer Leiterstufe angeordnet werden, dass sich erste und zweite Messung in ihrer Messposition relativ zum elektrischen Leiter (con) unterscheiden.

7. Verfahren nach Anspruch 6, bei dem bei dem die Messung des elektrischen Feldes (E1, E2) derart vorgenommen wird, dass mittels eines geerdeten Shutters (sh), wiederholt eine Sensorelektrodenanordnung von dem zu messenden Feld (E) abschirmt und wieder dem Feld (E) aussetzt wird, so dass die Sensorelektrodenanordnung hinter dem Shutter (sh) durch Influenz des zu messenden elektrischen Feldes (E) abwechselnd ent- und aufgeladen wird.

8. Anordnung einer Vorrichtung mit einem zu vermessenden elektrischen Leiter (con), wobei die Vorrichtung galvanisch getrennt mit dem elektrischen Leiter (con) angeordnet ist, welche Vorrichtung wenigstens eine Messeinrichtung (S1, S2) aufweist,

   wobei die Anordnung derart ausgestaltet ist, dass zumindest zwei Messungen einer ersten elektrischen Größe des zu vermessenden Leiters (con) vornehmbar sind, die sich in ihrer Messposition relativ zum elektrischen Leiter (con) unterscheiden,
   und umfassend eine Messsignalverarbeitungseinrichtung (cal), welche ausgestaltet ist, aus den Messungen eine weitere elektrische Größe (U) zu bestimmen.

9. Anordnung nach Anspruch 8, wobei die Messeinrichtung (S1) einen Sensor zur Messung einer elektrischen Feldstärke (E) umfasst.

10. Anordnung nach Anspruch 9, wobei der Sensor als mikroelektromechanische Feldmühle ausgestaltet ist.

11. Anordnung nach einem der vorstehenden Ansprüche 8 bis 10, wobei der elektrische Leiter oder zumindest ein zu vermessender Leiterabschnitt des elektrischen Leiters (con) zwischen einem ersten Abstand (d1) relativ zur Messeinrichtung (S1) und einem zweiten Abstand (d2) relativ zur Messeinrichtung (S1) beweglich angeordnet ist.

12. Anordnung nach einem der vorstehenden Ansprüche 8 bis 10, wobei die Vorrichtung eine erste und eine zweite Messeinrichtung (S1, S2) aufweist, welche erste und zweite Messeinrichtungen (S1, S2) derart beidseitig einer Leiterstufe angeordnet sind, so dass der Verlauf des elektrischen Leiters (con) vor und nach der Leiterstufe in unterschiedlichen Abständen (d1, d2) an den Messeinrichtungen (S1, S2) vorbeiführt.

13. Anordnung nach einem der vorstehenden Ansprüche 8 bis 12, wobei die Messeinrichtung (S1, S2) eine elektromagnetische Feldabschirmung (EMC) aufweist.

14. Anordnung nach einem der vorstehenden Ansprüche 8 bis 13, wobei die Messsignalverarbeitungseinrichtung (cal) eine Auswerteelektronik umfasst.

15. Anordnung nach einem der vorstehenden Ansprüche 8 bis 14, wobei die Messsignalverarbeitungseinrichtung (cal) eine Signalaufbereitung umfasst.

FIG 1

EP 4 644 920 A1

## FIG 2

EP 4 644 920 A1

FIG 3

FIG 4

EP 4 644 920 A1

## FIG 5

con

brd

con

con

S1

S2

d1

d2

brd

## FIG 6

A

1

2

3

4

1,6 +10% /- 10%

B

EP 4 644 920 A1

Europäisches Patentamt
European Patent Office
Office européen des brevets

# EUROPÄISCHER RECHERCHENBERICHT

Nummer der Anmeldung

EP 24 17 3406

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | US 2014/111189 A1 (MAKUTH JENS [DE] ET AL) 24. April 2014 (2014-04-24) | 1,2,4,5, 7-11, 13-15 | INV. G01R29/12 G01R15/14 |
| A | * Absätze [0002], [0004], [0016] - [0034], [0040] - [0055]; Abbildungen 1,2 * ----- | 6,12 | G01R15/16 ADD. G01R19/00 |
| X | US 4 724 393 A (KUMADA AKIRA [JP] ET AL) 9. Februar 1988 (1988-02-09) * Spalte 4, Zeile 25 - Spalte 8, letzter Zeile; Abbildungen 1,3,4,8,5 * ----- | 1-3,5, 7-11, 13-15 | |
| X | US 2014/218056 A1 (ALATAS FATIH [DE] ET AL) 7. August 2014 (2014-08-07) * Absätze [0016], [0037] - Absatz [0050]; Abbildungen 1B,3 * ----- | 1,3,5, 7-11, 13-15 | |
| A | DE 10 2008 052477 A1 (SIEMENS AG [DE]) 10. Juni 2010 (2010-06-10) * das ganze Dokument * ----- | 1-15 | RECHERCHIERTE SACHGEBIETE (IPC) G01R |

Der vorliegende Recherchenbericht wurde für alle Patentansprüche erstellt

| Recherchenort | Abschlußdatum der Recherche | Prüfer |
|---|---|---|
| München | 20. September 2024 | Hof, Klaus-Dieter |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument
.........................................................................
& : Mitglied der gleichen Patentfamilie, übereinstimmendes Dokument

EPO FORM 1503 03.82 (P04C03)

## ANHANG ZUM EUROPÄISCHEN RECHERCHENBERICHT
## ÜBER DIE EUROPÄISCHE PATENTANMELDUNG NR.

EP 24 17 3406

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

20-09-2024

| Im Recherchenbericht angeführtes Patentdokument | Datum der Veröffentlichung | Mitglied(er) der Patentfamilie | | Datum der Veröffentlichung |
|---|---|---|---|---|
| US 2014111189 A1 | 24-04-2014 | CN | 103460058 A | 18-12-2013 |
| | | EP | 2668512 A1 | 04-12-2013 |
| | | JP | 5951005 B2 | 13-07-2016 |
| | | JP | 2014514557 A | 19-06-2014 |
| | | US | 2014111189 A1 | 24-04-2014 |
| | | WO | 2012139648 A1 | 18-10-2012 |
| US 4724393 A | 09-02-1988 | KEINE | | |
| US 2014218056 A1 | 07-08-2014 | CN | 103765235 A | 30-04-2014 |
| | | DE | 102011081666 A1 | 28-02-2013 |
| | | EP | 2707734 A1 | 19-03-2014 |
| | | JP | 5989120 B2 | 07-09-2016 |
| | | JP | 2014525573 A | 29-09-2014 |
| | | US | 2014218056 A1 | 07-08-2014 |
| | | WO | 2013029915 A1 | 07-03-2013 |
| DE 102008052477 A1 | 10-06-2010 | KEINE | | |

EPO FORM P0461

Für nähere Einzelheiten zu diesem Anhang : siehe Amtsblatt des Europäischen Patentamts, Nr.12/82

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102010035381 A1
- DE 102008052477 A1